# EUROPÄISCHE PATENTSCHRIFT

(11) **EP 2 940 380 B1**
(45) Veröffentlichungstag und Bekanntmachung des Hinweises auf die Patenterteilung: **15.03.2017**
(21) Anmeldenummer: 15165061.1
(22) Anmeldetag: 24.04.2015
(51) Int. Cl.: F21V 31/00, F21V 31/03, F21S 8/10, F21V 15/01, F21V 17/10, F21V 17/16, H05K 5/00, H05K 5/06

(54) **DICHTUNG**
SEAL
JOINT

(30) Priorität: 29.04.2014 DE 202014102002 U
(43) Veröffentlichungstag der Anmeldung: 04.11.2015
(73) Patentinhaber: Zumtobel Lighting GmbH, 6850 Dornbirn (AT)
(72) Erfinder: Machate, Andreas, 88239 Wangen im Allgäu (DE)
(74) Vertreter: Kiwit, Benedikt

(56) Entgegenhaltungen:
- WO-A1-99/16618
- AT-B- 379 008
- CN-A- 101 776 256
- CN-U- 202 301 930
- DE-A1- 19 524 163
- DE-B3-102011 052 576
- DE-U1-202012 100 972
- GB-A- 742 899
- US-A- 3 659 896
- US-A1- 2012 140 437

## Beschreibung

Die Erfindung betrifft eine Dichtungsanordnung insbesondere für Leuchtengehäuse. Derartige Anordnungen sind an sich bekannt.

Üblicherweise werden zwischen zwei Gehäusehälften Dichtungen eingesetzt und mittels Schrauben derart verspannt, dass die Dichtung fest zwischen den Gehäusehälften eingepresst ist. Die Dichtung ist vorzugsweise umlaufend ausgebildet. Allerdings haben diese Dichtungen den Nachteil, dass sie bei der Montage in eine Gehäusehälfte eingelegt werden müssen, um daraufhin die andere Gehäusehälfte aufsetzen und verschrauben zu können. Damit die Dichtung beim Festschrauben der beiden Gehäuseteile miteinander nicht verrutscht, müssen zusätzliche Vorkehrungen getroffen werden, beispielsweise in Form eines formschlüssigen Eingriffs der Dichtung mit einem der Gehäuseteile. Ist das Gerät bzw. eine der beiden Gehäusehälften beispielsweise an einer Decke oder einer Wand eines Raums angebracht, und muss eine Person beispielsweise zu Wartungszwecken an das Innere des Geräts gelangen, muss sie die ihr zugewandte Gehäusehälfte abnehmen, d. h. beispielsweise abschrauben. Das dabei entstehende Problem ist, dass die Dichtung bei der Abnahme dieses Gehäuseteils abfallen kann. Nur wenn die Dichtung in einer der Gehäusehälften fixiert, beispielsweise verklemmt, ist, kann dies verhindert werden. D. h. eine der Gehäusehälften muss mit entsprechenden Fixierstrukturen versehen sein, um die Dichtung in Position zu halten. Dies führt zu einer konstruktiv aufwendigen Gestaltung und relativ teuren Herstellung.

Ein weiterer Nachteil ist, dass diese Dichtungen zu der jeweiligen Gehäusehälfte eine relativ große Auflagefläche aufweisen müssen. Dies ist insbesondere dem Fakt geschuldet, dass solche Dichtungen relativ steif sein müssen, um dem Druck aufgrund der zusammengeschraubten Gehäusehälften einen entsprechenden Wiederstand entgegensetzen zu können.

Bekannte Dichtungsanordnungen sind in GB 742 899 A, DE 195 24 163 A1, CN 202 301 930 U, US 2012/140437 A1 beschrieben.

Alternativ ist es auch denkbar, die Dichtwirkung über Verpressen kleiner Flächen mit hohem Druck in weiches Dichtmaterial zu bewirken, was ein stark verspanntes Material, Spannungskorrosion, Versprödung und Rissbildung über die Lebensdauer zur Folge hat. Um eine Durchbiegung der Gehäusehälften zu vermeiden, sind häufig biegesteife Geometrien mit zwangsläufig großer Bauteilhöhe notwendig. Dennoch lassen sich Spannungen im Material, Rissbildung an den Schraubpositionen sowie eine eventuelle Bauteildurchbiegung zwischen den Schraubpositionen meist nicht vermeiden.

Aufgabe der Erfindung ist es, den Nachteilen des Standes der Technik zu begegnen.

Diese Aufgabe wird durch den Gegenstand der unabhängigen Ansprüche gelöst. Vorteilhafte Weiterbildungen sind in den Unteransprüchen angegeben.

Erfindungsgemäß ist ein Gerät mit einem ersten Gehäuseabschnitt, einem zweiten Gehäuseabschnitt und einer Dichtung vorgesehen. Die Dichtung ist aus einem flexiblen und vorzugsweise reversiblem (elastischem) Material gebildet. Sie ist ferner so ausgebildet und zwischen den zwei Gehäuseabschnitten angeordnet, dass sie in einem Einpresszustand, zwischen den beiden Gehäuseabschnitten abdichtend eingepresst ist. Die Abdichtwirkung bzw. das Einpressen wird erreicht, indem zwischen Dichtung und angrenzendem Gehäuseabschnitt eine Adhäsionswirkung erzielt wird. Aufgrund dessen ist ein von den Gehäuseabschnitten und der Dichtung eingeschlossener Innenraum an den Übergängen zwischen Dichtung und jeweiligem Gehäuseabschnitt abgedichtet, sodass keine ungewollten Stoffe wie Flüssigkeiten in den Innenraum gelangen können. Dies ist insbesondere bei Geräten notwendig, die in feuchten Umgebungen wie einem Badezimmer betrieben werden sollen. Dränge Flüssigkeit ein, könnte die in solch einem Innenraum üblicherweise vorgesehene Elektronik Schaden nehmen. Ferner ist die Dichtung aufgrund der Adhäsionswirkung in diesem Zustand bis zu einem vorbestimmten Maß gehindert, sich von dem angrenzenden Gehäuseabschnitt zu lösen. Dies hat den Vorteil, dass etwaige, auf das Gerät wirkende thermische und/oder mechanische Einwirkungen nicht unmittelbar oder überhaupt keine Auswirkung auf die Dichtigkeit haben. Mechanische Einwirkungen können aufgrund eines Anschraubens des Geräts an einem Tragkörper wie einer Wand oder Decke eines Raums entstehen, indem aufgrund des Festschraubens das Material eines oder beider Gehäuseabschnitte so unter mechanische Spannung gerät, dass sich dieses Material verformt. Thermische Einwirkungen können insbesondere in den genannten Feuchträumen auftreten. Ist der Feuchtraum beispielsweise ein Badezimmer, verursacht ein Dusch- oder Badevorgang einer Person einen Temperaturanstieg im Raum, der leicht über übliche Raumtemperaturen von beispielsweise 22° C ansteigen kann. Demgegenüber kann ein Lüften des Raums im Winter zu einem Temperatursturz führen, was sich ebenfalls ungünstig auswirken kann. Solche Temperaturveränderungen haben in der Regel thermische Materialveränderungen im Gehäuse aufgrund eines Ausdehnens bzw. Zusammenziehens dessen Materials zur Folge Die Adhäsionswirkung hat zudem den Vorteil, dass die Dichtfläche der Dichtung in Bezug auf den jeweiligen Gehäuseabschnitt minimiert werden kann.

Das Gerät weist vorzugsweise ferner ein Spannmittel auf. Das Spannmittel ist so angeordnet, dass es die Gehäuseabschnitte so jeweils in Richtung Dichtung zusammendrückt, dass die Dichtung zwischen den zwei Gehäuseabschnitten abdichtend eingepresst ist. Sie befindet sich somit im Einpresszustand. D. h. das Spannmittel wirkt einem etwaigen Ausdehnungsdrang der Dichtung entgegen und gewährleistet die Abdichtung zu den Gehäuseabschnitten.

Das Spannmittel ist vorzugsweise mittels elastisch ausgebildeter Klammern gebildet. Diese sind außenumfangsseitig an den zwei Gehäuseabschnitten diese umgreifend angeordnet. Dabei werden die Klammern von den zwei Gehäuseabschnitten und der dazwischenliegenden Dichtung auseinandergedrückt und damit gespannt; bzw. umgekehrt: die Klammern drücken die Gehäuseabschnitte und die dazwischenliegende Dichtung zusammen. D. h. der Begriff Spannmittel betrifft nicht zwangsläufig ein einziges Teil. Diese Anordnung ist besonders einfach herzustellen und insbesondere für flachbauende Geräte, also Geräte mit insbesondere einem flach bauenden ersten Gehäuseabschnitt, geeignet. Schrauben sind zwar auch möglich, allerdings erfordern sie aufgrund der notwendigen Schraubgewinde eine gewisse Bauhöhe der gesamten Anordnung.

Die vorgenannte Adhäsionswirkung wird vorzugsweise zumindest teilweise dadurch erlangt, dass die Dichtung so gebildet und angeordnet ist, dass im Einpresszustand zwischen der Dichtung und zumindest einem der zwei Gehäuseabschnitte eine Saugwirkung entsteht. Dies scheint auf den ersten Blick widersprüchlich, da die Gehäuseabschnitte und die Dichtung zusammengedrückt werden. Allerdings ist es durch diese Ausgestaltung möglich, dass im Betrieb auftretende mechanische Belastungen wie Verwindung, Erschütterungen und dergleichen, die die Gehäuseabschnitte auseinander drängen könnten, aufgrund der Saugwirkung der Dichtung zumindest bis zu einem bestimmen Maß ausgeglichen werden können. Dadurch bleibt auch unter diesen Umständen die Dichtwirkung erhalten. Das Maß bestimmt sich aus der durch die Saugwirkung erzielten Kraft und das Maß, um dass sich die Dichtung entspannen kann, bevor sie von einem der Gehäuseabschnitte abheben muss.

Diese Saugwirkung wird vorzugsweise erlangt, indem die Dichtung in einem Nichteinpresszustand mit dem zumindest einen Gehäuseabschnitt einen Hohlraum komplett einschließt, der im Einpresszustand der Dichtung zumindest verringert ist. Die Saugwirkung entsteht also aufgrund eines Unterdrucks zwischen Dichtung und angrenzendem Gehäuseabschnitt. Der Unterdruck entsteht, da das elastische Material der Dichtung dazu neigt, sich von der Form im Einpresszustand zurück in Richtung ihrer Form im Nichteinpresszustand zu verformen und damit den besagten Hohlraum wieder zu vergrößern.

Der Hohlraum entsteht vorzugsweise, indem die Dichtung an einer zu dem zumindest einen Gehäuseabschnitt weisenden Seite eine in Richtung des zumindest einen Gehäuseabschnitts weisende Konkavität aufweist. Dies ermöglicht, die Dichtung an eine jeweils im Wesentlichen ebene Fläche anlegen zu können. Das Gehäuse benötigt also keine besonderen Strukturen.

Jede der vorgenannten Dichtungen kann mit zumindest einem der zwei Gehäuseabschnitte formschlüssig in Eingriff stehen. Zum einen kann dadurch eine Adhäsionswirkung zu einem der Gehäuseabschnitte bewirkt werden. Zum anderen ermöglicht dies, die Dichtung zunächst auf einen Gehäuseabschnitt aufsetzen und mit diesem formschlüssig in Eingriff bringen zu können, bevor der andere Gehäuseabschnitt aufgesetzt wird.

Jede Dichtung kann aus einem Zweikomponenten-Werkstoff gebildet sein. Dieser kann mittels Spritzgusses hergestellt sein. Dies ermöglicht die Nutzung eines formstabilen Materials für einen etwaigen formschlüssigen Eingriff und ein weniger formstabiles, dafür elastischeres und besser anliegendes Material für den abdichtenden Bereich der Dichtung beispielsweise um den Bereich des formschlüssigen Eingriffs herum. Die Dichtung kann also am jeweiligen Gehäuseabschnitt kraft- und/oder formschlüssig angebracht sein.

Vorzugsweise ist die Dichtung umlaufend ausgebildet. Dadurch ist es möglich, die Dichtung auf ebene Flächen der Gehäuseabschnitte abdichtend auflegen zu können. Die Gehäuseabschnitte benötigen keine extra Haltestrukturen für die Dichtung oder Strukturen, die an freien Enden der Dichtung abdichtend anliegen.

Die Dichtung ist vorzugsweise aus einem Endlosmaterial herausgeschnitten. Die daraus resultierenden zwei freien Enden des herausgeschnittenen Stücks sind aneinander gefügt. Das Fügen kann beispielsweise mittels Verschmelzens, Verklebens oder auch mittels formschlüssigen Eingriffs miteinander erfolgen. Diese Herstellung ist besonders preiswert, und dennoch kann die Dichtung als umlaufende Dichtung mit den Gehäuseabschnitten zum Einsatz gebracht werden. Zudem ist sie in der Länge an verschiedenartige Gehäuse auch während ein und desselben Produktionszyklus' veränderbar und damit anpassbar.

Vorzugsweise ist die Dichtung aus einem Silikon gebildet. Dieses Material ist insbesondere aufgrund seiner chemischen Bauteilbeständigkeit sehr gut im Elektronikbereich einsetzbar. Ein alternatives Material sind Silikoncompounds, die eine Art klebrige bzw. stark adhäsiv wirkende Oberfläche ausbilden und so in besonders guter Weise für die erfindungsgemäße Dichtung geeignet sind. Wiederum alternativ bieten sich einem Schmelzklebstoffe an, die als Silikone eingesetzt und insbesondere zum Verguss von/mit Leuchtmitteln verwendet werden kann. Diese Stoffe haben eine hohe Temperatur- und Medienbeständigkeit und können hochtransparent ausgebildet sein. Ein anderes geeignetes Material ist Elastomer mit vernetzter bzw. geschlossenporiger Oberfläche. Dadurch wird eine besonders gute Abdichtung erlangt. Schließlich kann auch ein Adhäsionsklebstoff zum Einsatz kommen, der dann an einem der Gehäuseabschnitte dauerhaft abdichtend anliegt.

Die Dichtung kann auch eine Schicht aus einer adhäsionsverstärkenden Flüssigkeit aufweisen. Dadurch kann das eigentliche Dichtungsmaterial aus einem weniger adhäsionswirksamen Material bestehen.

Diese Flüssigkeit kann aber auch eine geringere Adhäsionskraft aufweisen als die übrige Dichtung in Bezug auf den jeweils angrenzenden Gehäuseabschnitt. Dies ermöglicht, Dichtungsabschnitte vorzusehen, die an den Gehäuseabschnitten abdichtend anliegen und über die Flüssigkeit zueinander abgedichtet werden. Dies ermöglicht, die Dichtungsabschnitte vorab an den Gehäuseabschnitten anzuordnen bzw. auszubilden. Beim Zusammensetzen der Gehäuseabschnitte gelangen die Dichtungsabschnitte über die Flüssigkeit miteinander in abdichtenden Eingriff oder in Anlage. Dadurch ist eine Demontage eines Gehäuseabschnitts vom anderen möglich, ohne die Dichtung zu zerstören oder anderweitig zu beschädigen.

Vorzugsweise handelt es sich bei der Flüssigkeit um einen Klebstoff. Dies ermöglicht den Einsatz von zwei Komponenten, die zueinander eine größere Adhäsionskraft hätten als mit dem dazwischen angeordneten Klebstoff. So können die Gehäuseabschnitte ohne Weiteres auch hier wieder auseinandergenommen werden.

Die vorgenannten Geräte weisen ferner vorzugsweise jeweils einen Druckregulierungsabschnitt auf. Dieser ist gestaltet, einen Druckausgleich von einem von der Dichtung und den Gehäuseabschnitten umschlossenen Innenraum zu einer unmittelbaren Umgebung des Geräts zuzulassen. Dadurch wird der Fall vermieden, dass sich beispielsweise aufgrund einer Wärmeentwicklung im Inneren des Geräts gegenüber der unmittelbaren Umgebung des Geräts ein Überdruck aufbauen kann und dadurch in der Lage sein könnte, die Dichtung nach außen zu drücken. Dies könnte sonst zu einem zumindest teilweisen Verlust der Abdichtwirkung der Dichtung gegenüber den Gehäuseabschnitten führen. Allerdings ist der Druckregulierungsabschnitt gestaltet, Feuchtigkeit nicht durchzulassen.

Die Dichtung kann als Formteil, Spritzteil, Extrusionsteil oder Koextrusionsteil ausgebildet sein. Es sind mithin viele und preisgünstige Herstellungsverfahren möglich.

Jedes der vorgenannten Geräte kann als Leuchte ausgebildet sein. Insbesondere bei diesen Geräten kann die vorstehend angegebene Wärmeentwicklung im Inneren des Geräts entstehen. Zudem werden Leuchten häufig in Feuchträumen aufgehängt, sodass die Dichtigkeit in Bezug auf Feuchtigkeit relevant ist. Undichtigkeiten könnten zu Beschädigungen in der Elektronik und/oder zu Fehlfunktionen beispielsweise aufgrund von Korrosion im Gerät führen.

Die Dichtung kann zudem selbst mit Leuchtmitteln versehen sein. Es entsteht mithin ein kombiniertes Leucht- und Dichtungsmodul, das als Ganzes in die Gehäuseabschnitte eingesetzt werden kann. Es erfordert lediglich eine Anschlussmöglichkeit an eine externe Energieversorgung. Oder aber es ist eine drahtlose Energieübertragung beispielsweise unter Nutzung einer Planarspule vorsehbar.

Vorteilhafterweise sind die Leuchtmittel auf zumindest einer Leiterplatte angebracht und verschaltet. Die Verschaltung ist bekanntermaßen derart, dass die Leuchtmittel bei Anlegen einer elektrischen Energie zum Leuchten gebracht werden können. Die Leiterplatte ermöglicht das positionsgenaue Fixieren und elektrische Verschalten der Leuchtmittel. Die zumindest eine Leiterplatte ist in der Dichtung vergossen, verbunden mit den vorgenannten Vorteilen hinsichtlich der mit Leuchtmitteln versehenen Dichtung.

Vorzugsweise ist/sind zumindest einer der zumindest zwei Gehäuseabschnitte und/oder die Dichtung aus einem lichtdurchlässigen Material gebildet. Ist nur die Dichtung aus solch einem Material gebildet, ist eine indirekte Beleuchtung möglich. Ist sie zusammen mit einem Gehäuseabschnitt lichtdurchlässig ausgebildet, kann das Licht in Richtung Gehäuseabschnitt und seitlich im Bereich der Dichtung austreten. Sind alle drei Teile lichtdurchlässig ausgebildet, entsteht eine rundum leuchtende Lampe, wie dies bei einer Glühlampe der Fall ist.

Weitere Merkmale und Vorteile der Erfindung ergeben sich aus der nachfolgenden Beschreibung bevorzugter Ausführungsformen. Es zeigen:
- Figur 1: eine Leuchte gemäß einer Ausführungsform der Erfindung,
- Figur 2: die Leuchte in einer Explosionsansicht von unten in Figur 1,
- Figur 3: eine Schnittansicht entlang einer Linie A - A in Figur 1,
- Figur 4: den rechten Abschnitt der Leuchte von Figur 3 mit Klammer,
- Figur 5: eine Dichtung gemäß einer zweiten Ausführungsform der Erfindung und
- Figur 6: die Dichtung von Figur 5 in einer perspektivischen Ansicht.

Die Erfindung wird beispielhaft anhand einer Leuchte 1 beschrieben.

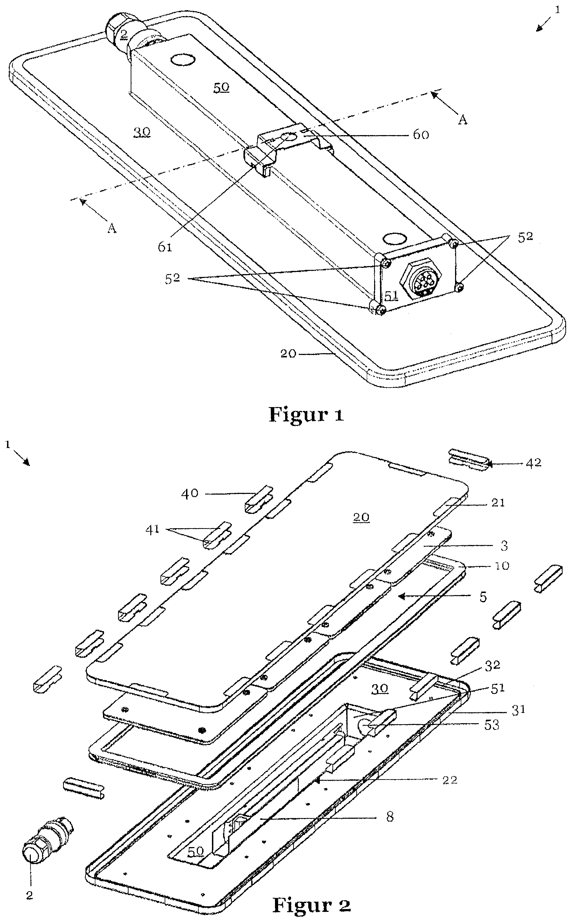

Figur 1 zeigt die Leuchte 1 in einer perspektivischen Ansicht in Richtung einer Anbringseite an einer Wand oder einer Decke eines Raumes. D. h. die Leuchte 1 strahlt in Figur 1 nach unten ab. Die Leuchte 1 besteht im Wesentlichen aus drei Gehäuseteilen 20, 30, 50. Die Gehäuseteile 20, 30 schließen hier nicht dargestellte Leuchtmittel 6 ein. Das Gehäuseteil 50 beinhaltet im Wesentlichen das Betriebsgerät für die Leuchte 1 und stellt somit ein Betriebsgehäuse dar. Das Betriebsgehäuse 50 ist abdichtend am Gehäuseteil 30 angebracht oder mit diesem einstückig ausgebildet. Das Gehäuseteil 20 ist, wie später näher erläutert, vorzugsweise in Richtung Gehäuseteil 30 offen ausgebildet. An der hier hinteren Stirnseite des Betriebsgehäuses 50 befindet sich ein Anschlusselement 2 zum Anschließen einer Energieversorgungsleitung bzw. eines externen Energieversorgungskabels. Dieses kann von einem Netzspannungsanschluss oder von einer anderen Leuchte 1 kommen, sodass eine Durchverdrahtung entsteht. Auf der gegenüberliegenden Stirnseite ist das Betriebsgehäuse 50 mittels eines Deckels 51 verschlossen, der mittels Schrauben 52 an dem Betriebsgehäuse 50 befestigt ist. Das Anschlusselement 2 und der Deckel 51 sind vorteilhafterweise jeweils feuchtigkeitsdicht an dem Betriebsgehäuse 50 angebracht. D. h. die im Betriebsgehäuse 50 aufgenommenen Teile sind zumindest vor Feuchtigkeit von außen geschützt. Ferner ist hier an der Oberseite des Betriebsgehäuses 50 eine Klammer 60 vorzugsweise klemmend angeordnet, die mittig eine Schrauböffnung 61 aufweist. Diese Öffnung dient dem Befestigen der Klammer 60 beispielsweise an einer Decke eines Raums, einer Halterung oder dergleichen. Die Leuchte 1 wird einfach mittels Einklipsens in die Klammer 60 fixiert und entsprechend im Raum angebracht.

Figur 2 zeigt die Leuchte 1 von Figur 1 in einer Explosionsansicht von einer zu Figur 1 entgegengesetzten Seite, d. h. von der Seite, in die die Leuchte 1 ihr Licht abstrahlt.

Hier ist besonders gut zu erkennen, dass das Betriebsgehäuse 50 und das Gehäuseteil 30 in einem Überlappungsbereich zueinander offen ausgebildet sind. Das Betriebsgehäuse 50 ist aufgrund seiner Ausbildung vorzugsweise an der in Richtung Gehäuseteil 30 weisenden Seite komplett offen. Da das Gehäuseteil 30 in diesem Bereich eine größere Fläche aufweist als besagte Seite des Betriebsgehäuses 50, weist das Gehäuseteil 20 hier eine Durchgangsöffnung 22 auf, die etwas kleiner ist als die offene Seite des Betriebsgehäuses 50. Dadurch ist es möglich, das Betriebsgehäuse 50 abdichtend auf das Gehäuseteil 20 aufzusetzen und beispielsweise mittels Verklebens daran zu fixieren.

Im somit zu einer Seite hin offenen Innenraum des Betriebsgehäuses 50 ist beispielhaft ein Betriebsgerät angeordnet, dass eine Halterung 8 aufweist, an der die elektronischen Bauelemente des Betriebsgerätes für die Leuchte 1 angeordnet bzw. befestigt sind.

An der hier nach hinten weisenden Stirnseite weist das Betriebsgehäuse 50 den Deckel 51 mit einer Durchgangsöffnung 53 für ein nicht dargestelltes Anschlusselement auf. Dieses Anschlusselement ist vorzugsweise am Deckels 51 abdichtend angebracht. An der anderen Stirnseite des Betriebsgehäuses 50 befindet sich das Anschlusselement 2.

Das Gehäuseteil 30 weist an einer vom Betriebsgehäuse 50 weg weisenden Seite einen vorzugsweise umlaufend ausgebildeten Vorsprung 32 auf, der in Bezug auf einen nicht bezeichneten Außenrand des Gehäuseteils 30 einen bestimmten Abstand aufweist. Auf diesen Vorsprung 32 ist eine Dichtung 10 vorzugsweise formschlüssig aufgesetzt. Die Dichtung 10 besteht dabei aus einem Material, dass beim Aufsetzen auf das Gehäuseteil 30 eine gewisse Adhäsionskraft auf dieses Gehäuseteil 30 ausüben kann. Dies ermöglicht, dass die Dichtung 10 an dem Gehäuseteil 30 haftet und beispielsweise bei einer Deckenkonstruktion nicht abfallen kann. Das Gehäuseteil 20 ist dementsprechend auf die dem Gehäuseteil 30 abgewandte Seite der Dichtung 10 aufgesetzt und beispielsweise mittels hier dargestellter Klammern 40, von denen nur eine mit Bezugszeichen versehen ist, an dem Gehäuseteil 30 fixiert. Dabei wird die Dichtung 10 etwas zusammengedrückt, sodass sie zumindest feuchtigkeitsdicht am Gehäuseteil 30 und 20 anliegt. Die Anpresskraft muss nur so hoch sein, dass die Dichtung 10 sicher einen Innenraum 5 nach außen hin abdichtet, der zwischen den Gehäuseteilen 20, 30 und der Dichtung 10 besteht.

Zum Aufsetzen der Klammern 40 weisen die Gehäuseteile 20, 30 miteinander vertikal fluchtende Klemmabschnitte 21, 31 auf. Diese sind im gezeigten Beispiel so ausgebildet, dass die Klammern 40 nicht in der Lage sind, die Gehäuseteile 20, 30 zu verbiegen. Ferner können über die Abschnitte 21, 31, sofern sie aus Metall bestehen, Stromübertragungen realisiert werden, um beispielsweise die Leuchte 1 zu erden. Die Klammern 40 weisen einen im Wesentlichen U-förmigen Querschnitt auf, der von zwei zueinander parallelen Vorsprüngen 41 eingeschlossen ist. D. h. die Klammern 40 weisen jeweils eine Ausnehmung 42 auf. Im Innenraum 5 sind hier beispielhaft vier Leiterplatten 3 angeordnet, die hier nicht sichtbare Leuchtmittel 6 beispielweise in Form von LEDs tragen, und von denen eine mit Bezugszeichen versehen ist.

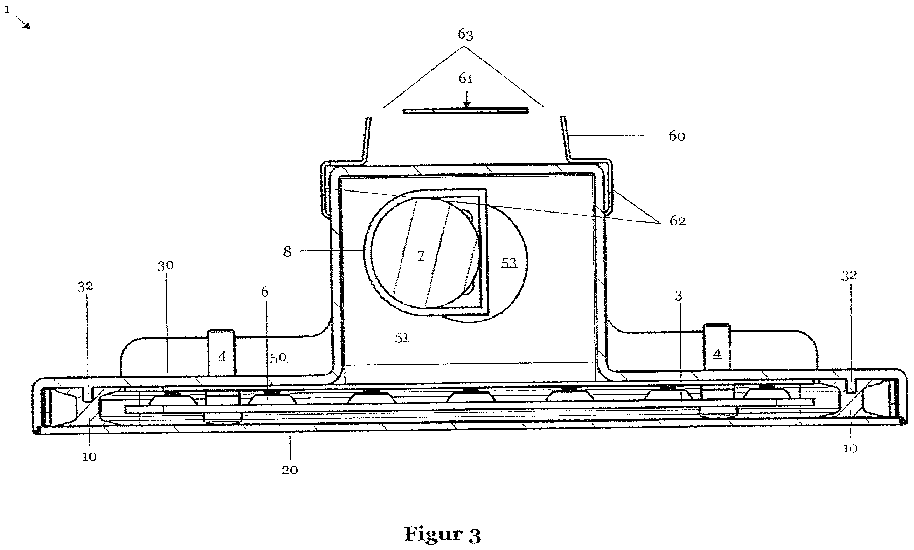

Figur 3 zeigt eine Schnittansicht der Leuchte 1 entlang einer Linie A-A in Figur 1.

In der Mitte ist ein Akkumulator 7 im Schnitt schematisch zu erkennen, der in der Halterung 8 des vorstehend angegebenen Betriebsgerätes angeordnet ist. Die Halterung 8 ist über hier nicht dargestellte Befestigungsvorrichtungen im Betriebsgehäuse 50 entsprechend fixiert. Hinter dem Betriebsgerät befindet sich der Deckel 51 mit der Durchgangsöffnung 53. Wie zu erkennen, sind das Betriebsgehäuse 50 und das Gehäuseteil 30 exemplarisch miteinander einstückig ausgebildet. Die Klammer 60 weist an oberen Eckbereichen Ausnehmungen 63 auf. Ferner ist in der Mitte die Schrauböffnung 61 andeutungsweise zu erkennen. Rechts- und linksseitig hier in Figur 3 weist die Klammer 60 zwei Spannabschnitte 62 in Form von federnden Klammerabschnitten auf. Die sich ein wenig aufeinander zu erstreckenden freien Enden dieser Spannabschnitte 62 klemmen die Leuchte 1 bzw. deren Betriebsgehäuse 50 in der Klammer 60 fest ein.

Die Leiterplatten 3, von denen hier eine gezeigt ist, sind vorzugsweise mittels Schrauben 4, 4 am Gehäuseteil 30 befestigt. Jede Leiterplatte 3 umfasst eine Mehrzahl von Leuchtmitteln 6, die hier in Form von LEDs ausgebildet sind. Diese strahlen in Richtung Gehäuseteil 20. Das Gehäuseteil 20 ist dementsprechend vorzugsweise aus einem transparenten Material gebildet. Dadurch ist es der Leuchte 1 möglich, Licht in den jeweiligen Raum abzustrahlen.

Hier rechts- und linksseitig der Leiterplatte 3 ist im Querschnitt die Dichtung 10 zu erkennen, die umlaufend ausgebildet ist. Ferner ist der vorstehend in Bezug auf Figur 2 angegebene Vorsprung 32 erkennbar, der von einer dem Gehäuseteil 20 zugewandten Innenseite des Gehäuseteils 30 in Richtung Gehäuseteil 20 hervorsteht. Auf diesen ist die Dichtung 10 formschlüssig in Eingriff stehend aufgesetzt.

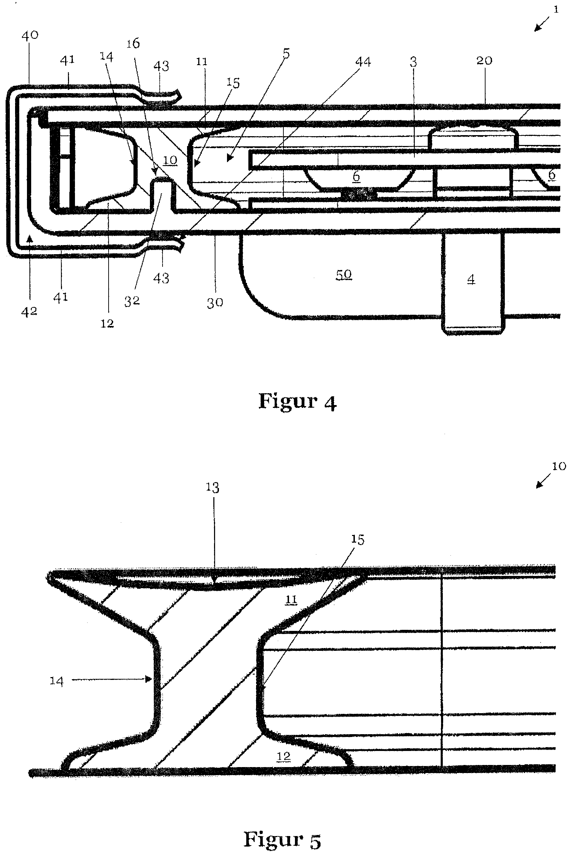

Figur 4 zeigt den rechten Bereich der Leuchte 1 von Figur 3 vergrößert im Ausschnitt und versehen mit einer Klammer 40. Auch hier ist die Anordnung der Leiterplatte 3 mit Leuchtmitteln 6 im Innenraum 5 inklusive Befestigungsschraube 4 zu erkennen. Die Schrauben 4 müssen nicht zwangsläufig eine Befestigungsfunktion haben. Sie können zusätzlich oder alternativ ausgebildet sein, die Leiterplatte 3 bzw. die darauf realisierte Schaltung zu erden oder in sonstiger Weise mechanisch und/oder elektrisch zu koppeln.

In dieser Ansicht ist besonders gut zu erkennen, wie die Dichtung 10 mit einer Ausnehmung 16 auf den Vorsprung 32 des Gehäuseteils 30 aufgesetzt ist. Die Dichtung 10 ist im gezeigten Beispiel im Querschnitt X-förmig ausgebildet. D. h. die Dichtung 10 weist an ihren in Richtung Gehäuseteil 20 und Gehäuseteil 30 weisenden Seiten verbreiterte Fußabschnitte 11, 12 auf. Diese sind so ausgebildet, dass sie auf das angrenzende Gehäuseteil 20, 30 bzw. dessen ihnen zugewandte Seite eine gewisse Adhäsionskraft ausüben. Diese kann im gezeigten Beispiel mittels press Anliegens des Materials an der Dichtung 10 erfolgen.

Die Fußabschnitte 11, 12 sind vorzugsweise aus einem gegenüber dem Rest der Dichtung 10 weniger formstabilen, dafür aber eine Adhäsion mit dem angrenzenden Gehäuseteil 20, 30 erzeugenden Material ausgebildet. Dadurch gelangen die Fußabschnitte 11, 12 mit den Gehäuseteilen 20, 30 beim Einsetzen der Dichtung 10, spätestens jedoch beim Aufschieben der Klammern 40, abdichtend in Anlage. Die Adhäsion bewirkt vorteilhafterweise, dass sich die Gehäuseteile 20, 30 von sich aus nicht von der Dichtung 10 lösen können. Diese Ausbildung erlaubt die Herstellung der Dichtung beispielsweise als Koextrusionsteil bzw. -profil.

Alternativ oder zusätzlich kann zwischen der Dichtung 10 und beispielhaft dem Gehäuseteil 20 eine Saugwirkung erzielt werden, wie sie nachstehend in Bezug auf Figur 5 beschrieben wird. Aufgrund der Querschnittsform der Dichtung 10 weist diese in Richtung Innenraum 5 und in Richtung vom Innenraum 5 weg eine jeweilige Ausnehmung 14, 15 auf. Die Klammer 40 weist aufgrund ihrer nutenförmigen Ausbildung einen Innenraum 42 auf, der dem Aufnehmen der zusammengefügten Gehäuseteile 20, 30 mit dazwischenliegender Dichtung 10 dient. Die Vorsprünge 41 weisen an ihren einander zugewandten Seiten im Bereich ihrer freien Enden Flächen 44 auf, die in Richtung freies Ende voneinander weg weisen und somit eine Anlaufschräge für die zusammengefügten Gehäuseteile 20, 30 bilden. Wird die Klammer 40 hier von links auf das Gehäuse 20, 30 aufgeschoben, werden die Vorsprünge 41 aufgrund der Anlaufschrägen 44 auseinander gedrängt, sodass die Klammer 40 mit ihren federnd ausgebildeten Vorsprüngen 41, 41 die Gehäuseteile 20, 30 zusammendrückt und damit gegen die innen angeordnete Dichtung 10 drängt. Dadurch wird die Dichtung 10 abdichtend an die ihr zugewandten Innenseiten der Gehäuseteile 20, 30 anliegend angeordnet.

Die Vorsprünge 41 weisen im Bereich ihrer freien Enden einen jeweiligen Abschnitt 43 auf. Die Abschnitte 43 haben zueinander einen geringeren Abstand als die sonstigen Bereiche der Vorsprünge 41 zueinander. Dies ermöglicht, dass die Klammer 40 nur im Bereich der Abschnitte 43, 43 an den Gehäuseteilen 20, 30 diese einspannend bzw. einklemmend anliegt. Der Anlagebereich ist vorzugsweise derart, dass die Vorsprünge 43, 43 mittig in Bezug auf die Dichtung 10 gegen diese drücken. Dadurch wird der Druck der Klammer 40 über die Abschnitte 43, 43 und die Gehäusehälften 20, 30 im Wesentlichen senkrecht und vorteilhafterweise entlang ein und derselben Kraftlinie in die Dichtung 10 bzw. deren Mitte eingeleitet. Dadurch wirkt auf die Dichtung 10 keine Kraft, die die Dichtung 10 hier nach rechts oder nach links drängen könnte. D. h. die Dichtung 10 ist sicher in ihrer Position gehalten.

Figur 5 zeigt eine Dichtung 10 gemäß einer zweiten Ausführungsform der Erfindung.

Die Dichtung 10 unterscheidet sich von der ersten Ausführungsform der Erfindung im Wesentlichen darin, dass hier die Ausnehmung 16 fehlt. Ferner weist die Dichtung 10 beispielshaft im Bereich des Fußabschnitts 11 eine Konkavität auf. Dadurch bildet die Dichtung 10 hier an einer Oberseite eine vorzugsweise umlaufend Ausnehmung 13 aus. Aufgrund der umlaufenden Ausbildung der Dichtung 10 schließt diese mit dem darauf aufgesetzten, hier nicht dargestellten Gehäuseteil 20 zunächst einen Hohlraum ein. Wird die Klammer 40, wie vorstehend beschrieben, auf die Gehäuseteile 20, 30 geschoben, wird das Gehäuseteil 20 in Richtung Gehäuseteil 30 gedrängt, und der Hohlraum zwischen der Dichtung 10 und dem Gehäuseteil 20 wird vorzugsweise komplett geschlossen. D. h. die zwischen Dichtung 10 und Gehäuseteil 20 befindliche Luft wird komplett verdrängt. Aufgrund der flexiblen Ausgestaltung der Dichtung 10 entsteht damit zwischen Gehäuseteil 20 und Dichtung 10 ein Unterdruck, der dafür sorgt, dass das Gehäuseteil 20 an der Dichtung 10 bis zu einem vorbestimmten Maß festgehalten wird. Dieses vorbestimmte Maß entspricht der aus dem Unterdruck resultierenden Haltekraft zwischen Dichtung 10 und Gehäuseteil 20.

Ist die Leuchte 1 also, wie vorstehend beschrieben, deckenseitig montiert, und werden die Klammern 40 zu Wartungszwecken entfernt, kann das Gehäuseteil 20 nicht ohne weiteres abfallen. Dadurch ist die Bediensicherheit erhöht, und die Person kann nicht von einer fallenden Abdeckung verletzt werden.

Die vorstehend angegebenen Klammern 40 bewirken, dass auch hier die Dichtung 10 sicher in Position gehalten wird.

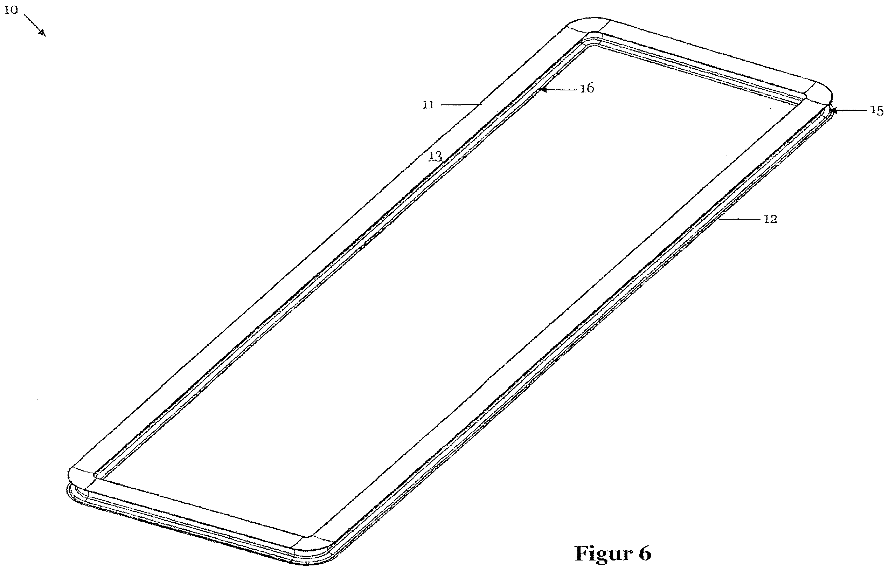

Figur 6 zeigt die Dichtung 10 von Figur 5 in einer perspektivischen Ansicht. Die Ausnehmung 13 ist exemplarisch auf der hier nach oben weisenden Seite der Dichtung 10 ausgebildet. Ferner sind die Fußabschnitte 11, 12 andeutungsweise zu erkennen sowie die dazwischen ausgebildeten Ausnehmungen 15, 16.

Die Erfindung ist nicht auf die vorstehend beschriebenen Ausführungsformen beschränkt.

Beispielsweise kann die in Figur 5 gezeigte Dichtung 10 auch an ihrer Unterseite eine entsprechende Ausnehmung 13 aufweisen. Ferner können die Ausnehmungen 16 an beiden Seiten der Dichtung 10 ausgebildet sein. Zudem kann die Ausnehmung 16 sowie der damit korrespondierende Vorsprung 32 jegliche Querschnittsform annehmen, die dazu dient, die Dichtung 10 entsprechend in Anlage mit dem jeweiligen Gehäuseteil zu bringen. Beispielsweise kann vorgesehen sein, dass der Vorsprung 32 eine pilzkopfartige Querschnittsform aufweist, sodass die Dichtung 10 mit einer vorzugsweise komplementär ausgebildeten Ausnehmung 16 diesen hintergreift und damit beispielsweise am Gehäuseteil 30 festgehalten wird. Die Ausnehmung 16 ist dabei so gestaltet, dass die Dichtung 10 aufgrund ihres Materials sicher mit dem Gehäuseteil 30 eine adhäsive Wirkung erlangt.

Die Dichtung 10 weist zumindest an den den Gehäuseteilen 20, 30 zugewandten Dichtflächen einen elastischen Dichtstoff auf, der sich mittels geringerer Kräfte mit dem angrenzenden Gehäuseteil verbinden kann als die Kraft, die von den Klammern 40 erzeugt wird. Der Dichtstoff bildet damit einen zumindest wasserundurchlässigen Verbund mit dem Gehäuseteil mittels Adhäsion.

Vorzugsweise erfolgt die Dichtwirkung unmittelbar beim Aufbringen der Dichtung 10 auf das Gehäuseteil 20, 30. Dazu kann die Dichtung 10 aus einem modifizierten Material gebildet sein, das lediglich eine Berührung und einen geringen Anpressdruck auf das Gehäuseteil 20, 30 beispielsweise aufgrund lediglich des Gewichts der Dichtung 10 erfordert. Dazu eignen sich Silikoncompounds, die eine "klebrige" bzw. stark adhäsiv wirkende Oberfläche ausbilden, sodass die Dichtwirkung sehr schnell eintritt. Ferner ist Silikon sehr gut für den Elektronikbereich einsetzbar, da er chemisch beständig ist.

Wird der Dichtung 10 auch noch eine geeignete Form, wie vorstehend beschrieben, gegeben, in dem sie beispielsweise eine elastische, konkave Form nach dem Prinzip eines Saugnapfes mit länglicher Erstreckung ausbildet, ist es möglich, die Anzahl und Auflagebreite von Verschlusselementen wie den vorgenannten Klammern 40 zu verringern. Ferner kann die Auflagefläche der Dichtung 10 am Gehäuseteil 20, 30 reduziert werden. Aufgrund der Saugwirkung erzeugt die Dichtung 10 die notwendigen Haltekräfte selbst. Sie muss nur daran gehindert werden, sich wieder zu entspannen, wofür die vorgenannten Klammern 40 beispielhaft genannt sind. An Stelle der Klammern 40 ist aber auch beispielsweise eine Schraubverbindung zwischen beiden Gehäuseteilen 20, 30 denkbar, die die Dichtung 10 unter Spannung setzt.

Um zu verhindern, dass sich beim Betrieb entwickelnde Wärme im Innenraum 5 so auswirkt, dass es die Dichtung 10 nach außen in Bezug auf das Gehäuse 20, 30 drückt und eventuell die Dichtwirkung reduziert, ist vorzugsweise vorgesehen, dass an einer Stelle des Gehäuses 20, 30 oder auch des Betriebsgehäuses 50 eine luftdurchlässige Membran ausgebildet ist, die dafür sorgt, dass im Innenraum 5 kein Überdruck entstehen kann. Alternativ ist eine Formgebung möglich, mit der die Dichtung 10 in Richtung Gehäuseäußeres an einer jeweiligen Seite des Gehäuseteils 20, 30 zu liegen kommt. Dies würde bedeuten, dass der Überdruck die Dichtung 10 gegen ebendiese Seite des jeweiligen Gehäuses 20, 30 drückt und nicht aus diesem heraus drücken kann. Die Dichtung 10 bleibt in Position, und die Dichtwirkung bleibt aufrecht erhalten.

Das feuchtigkeitsdichte Anordnen der Dichtung 10 an den Gehäuseteilen 20, 30 ermöglicht den Einsatz eines derartigen Geräts bzw. einer derartigen Leuchte 1 in Feuchträumen, wie beispielsweise in Badezimmern.

Die Dichtung 10 kann aus verschiedenen Stoffen bestehen. Beispielsweise kann vorgesehen sein, dass die Dichtung 10 in der Mitte, also in einem Bereich, der nicht an einem der Gehäuseteile 20, 30 anliegt, aus einem relativ formbeständigen Material gebildet ist. An seinen den Gehäuseteilen 20, 30 zugewandten Abschnitten ist die Dichtung 10 aus einem für die Dichtungswirkung geeigneten, die vorgenannte Adhäsion bewirkenden Material gebildet. Dies ermöglicht, die Ausbildung der Dichtung 10 als Form-, Spritzguss-, Extrusions-, oder Koextrusionsteil.

Auch wenn die Dichtung 10 als umlaufend ausgebildet dargestellt wurde, ist klar, dass sie auch nicht umlaufend ausgebildet sein kann. Sie kann sich beispielsweise mit ihren beiden freien Enden an einem der Gehäuseteile 20, 30 abstützen, oder beispielsweise über eine Feder-Nut-Verbindung in das jeweilige Gehäuseteil 20, 30 eingeschoben sein. Solch eine Feder-Nut-Verbindung kann beispielsweise mittels einer Schwalbenschanzführung realisiert werden. Sie muss daher mit ihren freien Enden stirnseitig an einem der Gehäuseteile 20, 30 lediglich jeweils abdichtend anliegen. Dies könnte bei Geräten sinnvoll sein, bei denen ein Deckel als ein Gehäuseteil gegenüber einem anderen Gehäuseteil mit korrespondierender Öffnung abgedichtet werden muss. Dazu kann die Dichtung 10 außerhalb der Anlenkung des Deckels am anderen Gehäuseteil am Deckel oder ebenjenem anderen Gehäuseteil abdichtend angebracht sein. Beim Schließen des Deckels kommen dessen abzudichtenden Ränder und die abzudichtenden Ränder des anderen Gehäuseteils mit der Dichtung 10 abdichtend in Anlage.

Oder aber ein Teil der Dichtung 10 ist an einem Gehäuseabschnitt angeordnet, und der andere Teil an dem anderen Gehäuseabschnitt. Beim Zusammenfügen beider Gehäuseabschnitte kommen die zwei Teile der Dichtung 10 an ihren freien Enden miteinander abdichtend in Anlage, sei es mittels kraft- und/oder formschlüssigen Ineinandergreifens.

Beide Arten von Dichtungen 10 (umlaufend und nicht umlaufend) können gebildet werden, indem ein Endlosprofil hergestellt wird, beispielsweise mittels Koextrusion, das dann entsprechend der gewünschten Länge der Dichtung 10 abgelängt wird. Nach dem Ablängen wird die Dichtung 10, wenn sie umlaufend ausgebildet werden soll, an ihren somit zwei freien Enden miteinander verbunden.

Ferner kann vorgesehen sein, dass an den Abschnitten der abdichtenden Anlage mit dem Gehäuseteil 20, 30 eine Flüssigkeit mit adhäsionsverstärkender Wirkung aufgebracht wird. Dies ermöglicht, die Gehäuseteile 20, 30 wieder auseinandernehmen zu können, ohne die Dichtungsanordnung zu verlieren, oder die Dichtung 10 austauschen zu müssen. Dies kann alternativ oder zusätzlich erlangt werden, indem die Dichtung 10 mit beiden Gehäuseteilen 20, 30 formschlüssig in Eingriff gelangt. Dies kann erreicht werden indem die Gehäuseteile 20, 30 einfach aufeinander gesetzt werden. Dazu können beide Gehäuseteile 20, 30 an den einander zugewandten Seiten bzw. Flächen Vorsprünge beispielsweise mit kreisförmigem Querschnitt aufweisen, und die Dichtung 10 weist an korrespondierenden, gegenüberliegenden Abschnitten konkave, vorzugsweise komplementär zu den Vorsprüngen ausgebildete Ausnehmungen auf. Sind dazu seitlich dieser Ausnehmungen noch die Fußabschnitte 11, 12 ausgebildet, kann sichergestellt werden, dass die Dichtung 10 sicher in Dichtanlage gelangt, obwohl möglicherweise die freistehenden Vorsprünge, die die Ausnehmung bilden, von den korrespondierenden Vorsprüngen an den Gehäuseseiten 20, 30 auseinander gedrückt werden.

Ferner kann die Dichtung 10 anstelle der Ausnehmung 16 auch einen Vorsprung aufweisen, der in eine korrespondierende Ausnehmung an bzw. in dem jeweiligen Gehäuseteil 20, 30 abdichtend eingeschoben wird. Die Dichtung 10 kann vorzugsweise aus einem Material gebildet sein, das eine Shore-Härte gemäß dem Maß A30 oder A10 aufweist. Es kann aus einem beliebigen Elastomer gebildet werden, das eine vernetzte also geschlossenporige Oberfläche aufweist und somit sicher abdichtend mit dem jeweiligen Gehäuseteil 20, 30 in Anlage kommt. Ist die Dichtung 10 beispielsweise aus Silikon gebildet, kann dieses transparent ausgebildet sein. Dies ermöglicht, Leuchtmittel 6 in die Dichtung 10 zu integrieren, d. h. vorzugsweise mit der Dichtung 10 zu umgießen. Dies kann selbstverständlich auch mit anderen Bauelementen oder mit den gesamten Leiterplatten 3 oder sonstigen elektronischen Bauelementen oder Schaltungen erfolgen. Dadurch kann schlussendlich ein komplettes Leucht- und Dichtmodul gebildet werden, dass zur Kontaktierung mit dem Betriebsgerät einfach maximal zwei Anschlüsse nach außen hat und sonst als Ganzes nur zwischen die Gehäuseteile 20, 30 gelegt werden muss, und die Leuchte 1 ist komplett, sobald die Gehäuseteile 20, 30 aneinander fixiert sind.

Die im Rahmen der Erfindung vorgesehene Adhäsionswirkung zwischen Dichtung 10 und angrenzendem Gehäuseabschnitt 20, 30 kann so stark ausgelegt sein, dass beispielsweise der Gehäuseabschnitt 20 bei deckenmontierter Leuchte 1 allein durch die Dichtung 10 gehalten wird. Um zu vermeiden, dass aus nicht vorhersehbaren Gründen trotz allem während des Betriebs der Gehäuseabschnitt 20, der beispielsweise als Scheibe ausgebildet sein kann, herabfällt (was beispielsweise durch die während des Betriebs auftretende Wärme im Innenraum 5 hervorgerufen werden könnte), sind zusätzliche Befestigungen beispielsweise in Form der vorgenannten Klammnern 40 vorsehbar. Die Klammern 40 stellen in dem Fall in erster Linie eine Sicherheitsmaßnahme dar, spielen allerdings insbesondere für die Dichtwirkung zwischen Dichtung 10 und Gehäuseabschnitten 20, 30 keine entscheidende Rolle. Vorzugsweise dienen die Klammern 40 also dem Sicherstellen der dauerhaften Dichtwirkung zwischen Dichtung 10 und Gehäuseabschnitten 20, 30.

Die vorgenannte Ausnehmung 13 dient, wie beschrieben, dem Ausbilden eines Hohlraums hier zum Gehäuseabschnitt 20. Es ist klar, dass diese Ausnehmung 13 jedwede andere Form annehmen kann, sofern der Hohlraum zum angrenzenden Gehäuseabschnitt 20, 30 beim Andrücken der Dichtung 10 in ihren Einpresszustand an ebendiesen Gehäuseabschnitt 20, 30 zumindest verkleinert, wenn nicht gar beseitigt wird. Der angrenzende Gehäuseabschnitt 20, 30 muss keine ebene Auflagefläche für die Dichtung 10 hinsichtlich des Hohlraums aufweisen. Sie muss nur so geformt sein, dass, wenn die Dichtung 10 nicht angepresst ist, mit dieser Fläche einen Hohlraum vollständig einschließt. Beispielsweise könnte diese Fläche eine Konvexität in Richtung Dichtung 10 aufweisen, deren Krümmung jedoch geringer ist als die Krümmung der vorgenannten Konkavität 13.

Auch könnten die Fläche dieses Gehäuseabschnitts 20, 30 beispielsweise eine Konkavität aufweisen und die Dichtung 10 am gegenüberliegenden Rand eben ausgebildet sein. Der Hohlraum dazwischen wird ebenfalls beim Zusammendrücken von Dichtung 10 und korrespondierendem Gehäuseabschnitt 20, 30 zumindest verkleinert, womit wieder die vorgenannte Saugwirkung entsteht.

Auch wenn die Erfindung in Verbindung mit einer Leuchte beschrieben wurde, ist klar, dass die Erfindung auf jedes Gerät anwendbar ist, das eine Abdichtung eines ihrer Innenräume nach außen erfordert.

Wesentlich ist, dass die Dichtung 10 aufgrund eine Adhäsionswirkung mit dem jeweils angrenzenden Gehäuseteil 20, 30 als Gehäuseabschnitt hat und dadurch mit relativ geringen Kräften an diesen Gehäuseteil 20, 30 anhaftet und eine Abdichtung ermöglicht, sei es mittels geeigneter Materialauswahl und/oder entsprechend ausgebildeter Konturen/Strukturen.

Im Ergebnis schafft die Erfindung eine enorm einfache Lösung, Gehäuse von nach außen zumindest feuchtigkeitsabgedichtet auszubildenden, insbesondere elektronischen Geräten zu realisieren, und das mit einfachen und preiswerten Mitteln. Überdies können derartige Dichtungen sehr klein ausgeführt werden, sodass zumindest Material eingespart wird.

### Bezugszeichenliste

- 1: Leuchte
- 2: Anschlussabschnitt
- 3: Leiterplatte
- 4: Schraube
- 5: Innenraum
- 6: Leuchtmittel
- 7: Akkumulator
- 8: Halterung
- 10: Dichtung
- 11: Fußabschnitt
- 12: Fußabschnitt
- 13: Ausnehmung
- 14: Ausnehmung
- 15: Ausnehmung
- 16: Ausnehmung
- 20: Gehäuseteil
- 21: Klemmabschnitt
- 22: Durchgangsöffnung
- 30: Gehäuseteil
- 31: Klemmabschnitt
- 32: Vorsprung
- 40: Klammer
- 41: Vorsprung
- 42: Ausnehmung
- 43: Abschnitt
- 44: Schräge
- 50: Betriebsgehäuse
- 51: Deckel
- 52: Schraube
- 53: Durchgangsöffnung
- 60: Klammer
- 61: Schrauböffnung
- 62: Spannabschnitt
- 63: Ausnehmung

## Patentansprüche

1. Leuchte (1) mit
• einem ersten Gehäuseabschnitt (20),
• einem zweiten Gehäuseabschnitt (30) und
• einer Dichtung (10), die
- aus einem flexiblen Material gebildet ist,
- so ausgebildet und zwischen den zwei Gehäuseabschnitten (20, 30) angeordnet ist, dass sie in einem Einpresszustand zwischen den beiden Gehäuseabschnitten (20, 30) abdichtend derart eingepresst ist, dass zwischen Dichtung (10) und angrenzendem Gehäuseabschnitt (20, 30) eine Adhäsionswirkung vorliegt, und
- im Querschnitt X-förmig ausgebildet ist, so dass sie an ihren in Richtung der jeweiligen Gehäuseabschnitte (20, 30) weisenden Seiten verbreiterte Fußabschnitte (11, 12) aufweist,
wobei die Adhäsionswirkung zumindest teilweise erlangt wird, indem die Dichtung (10) so gebildet und angeordnet ist, dass im Einpresszustand zwischen der Dichtung (10) und zumindest einem der zwei Gehäuseabschnitte (20, 30) eine Saugwirkung entsteht.

2. Leuchte (1) gemäß Anspruch 1, ferner aufweisend ein Spannmittel (40), das so angeordnet ist, dass es die Gehäuseabschnitte (20, 30) so jeweils in Richtung Dichtung (10) zusammendrückt, dass die Dichtung (10) zwischen den zwei Gehäuseabschnitten (20, 30) abdichtend eingepresst ist und sich somit im Einpresszustand befindet,
wobei das Spannmittel (40) vorzugsweise mittels elastisch ausgebildeter Klammern (40) gebildet ist, die
• außenumfangsseitig an den zwei Gehäuseabschnitten (20, 30) diese umgreifend angeordnet sind und
• von den zwei Gehäuseabschnitten (20, 30) und der Dichtung (10) auseinandergedrückt und damit gespannt werden.

3. Leuchte (1) gemäß Anspruch 1 oder 2, wobei die Saugwirkung erlangt wird, indem die Dichtung (10) in einem Nichteinpresszustand mit dem zumindest einen Gehäuseabschnitt (20, 30) einen Hohlraum komplett einschließt, der in dem Einpresszustand der Dichtung (10) zumindest verringert ist,
wobei vorzugsweise der Hohlraum entsteht, indem die Dichtung (10) an einer zu dem zumindest einen Gehäuseabschnitt (20, 30) weisenden Seite eine in Richtung des zumindest einen Gehäuseabschnitts (20, 30) weisende Konkavität (13) aufweist.

4. Leuchte (1) gemäß einem der vorhergehenden Ansprüche, wobei die Dichtung (10) mit zumindest einem der zwei Gehäuseabschnitte (20, 30) formschlüssig in Eingriff steht, und/oder wobei die Dichtung (10) an einem der Gehäuseabschnitte (20, 30) kraft- und/oder formschlüssig angebracht ist.

5. Leuchte (1) gemäß einem der vorhergehenden Ansprüche, wobei die Dichtung (10) aus einem Zweikomponenten-Werkstoff gebildet ist.

6. Leuchte (1) gemäß einem der vorhergehenden Ansprüche, wobei die Dichtung (10) umlaufend ausgebildet ist,
wobei die Dichtung (10) vorzugsweise
• aus einem Endlosmaterial herausgeschnitten, und
• dessen daraus resultierende Enden aneinander gefügt sind.

7. Leuchte (1) gemäß einem der vorhergehenden Ansprüche, wobei die Dichtung (10) gebildet ist aus
• einem Silikon,
• einem Silikoncompound,
• einem Schmelzklebstoff,
• einem Elastomer mit vernetzter bzw. geschlossenporiger Oberfläche oder
• einem Adhäsionsklebstoff.

8. Leuchte (1) gemäß einem der vorhergehenden Ansprüche, wobei die Dichtung (10) ferner eine Schicht aus einer Adhäsion verstärkenden Flüssigkeit aufweist.

9. Leuchte (1) gemäß Anspruch 8, wobei die Flüssigkeit eine geringere Adhäsionskraft aufweist als die übrige Dichtung (10) in Bezug auf den jeweils angrenzenden Gehäuseabschnitt (20, 30), und/oder
wobei die Flüssigkeit ein Klebstoff ist.

10. Leuchte (1) gemäß einem der vorhergehenden Ansprüche, ferner aufweisend einen Druckregulierungsabschnitt, gestaltet, einen Druckausgleich von einem von der Dichtung (10) und den Gehäuseabschnitten (20, 30) umschlossenen Innenraum (5) zu einer unmittelbaren Umgebung der Leuchte (1) zuzulassen.

11. Leuchte (1) gemäß einem der vorhergehenden Ansprüche, wobei die Dichtung (10) ausgebildet als
• Formteil,
• Spritzteil,
• Extrusionsteil oder
• Koextrusionsteil.

12. Leuchte (1) gemäß einem der vorhergehenden Ansprüche , wobei die Dichtung (10) mit Leuchtmitteln (6) versehen ist,
wobei vorzugsweise
• die Leuchtmittel (6) auf zumindest einer Leiterplatte (3) angebracht und verschaltet sind und
• die zumindest eine Leiterplatte (3) in der Dichtung (10) vergossen ist.

13. Leuchte (1) gemäß Anspruch 12, wobei zumindest einer der zumindest zwei Gehäuseabschnitte (20, 30) und/oder die Dichtung (10) aus einem lichtdurchlässigen Material gebildet ist bzw. sind.

## Claims

1. Luminaire (1) with
• a first housing section (20),
• a second housing section (30) and
• a seal (10), which
- is formed from a flexible material, and
- is so designed and arranged between the two housing sections (20, 30) that in a pressed-in state, it is so sealingly pressed between the two housing sections (20, 30), that an adhesion effect is exerted between the seal (10) and the adjacent housing section (20, 30), and
- has an X-shaped cross-section so that on its sides which point in the direction of the respective housing sections (20, 30), it has widened foot sections (11, 12),
wherein the adhesion effect is at least partially obtained by forming the seal (10) in such a way that a suction effect is produced between the seal (10) and at least one of the two housing sections (20, 30) in the pressed-in state.

2. Luminaire (1) according to claim 1, further comprising a clamping means (40) that is so arranged that it presses together the housing sections (20, 30) in the direction of the seal (10), so that the seal (10) is sealingly pressed between the two housing sections (20, 30) in the pressed-in state,
wherein the clamping means (40) is preferably formed by means of elastically-formed clamps (40), wherein
• they are arranged on and clamp the two housing sections (20, 30) on the outer circumference side;
• and are pushed apart by the two housing sections (20, 30) and the seal (10) and are thus tensioned.

3. Luminaire (1) according to claim 1 or 2, wherein the suction effect is obtained by completely closing the seal (10) in a non-pressed-in state with the at least one housing section (20, 30) in order to completely enclose a cavity which is at least reduced in the pressed-in state of the seal (10),
wherein preferably a cavity is formed in which the seal (10) comprises a concavity (13) pointing in the direction of the at least one housing section (20, 30) on a side facing the at least one housing section (20,30).

4. Luminaire (1) according to one of the preceding claims, wherein the seal (10) engages positively with at least one of the two housing sections (20, 30), and/or wherein the seal (10) is applied to one of the housing sections (20, 30) in a positive and/or frictional manner.

5. Luminaire (1) according to one of the preceding claims, wherein the seal (10) is formed from a two-component material.

6. Luminaire (1) according to one of the preceding claims, wherein the seal (10) is designed to be circumferential,
wherein the seal (10) is preferably
• cut out from a continuous material, and
• the resulting ends are joined together.

7. Luminaire (1) according to one of the preceding claims, wherein the seal (10) is formed from
• a silicone,
• a silicone compound,
• a hotmelt adhesive,
• an elastomer with a cross-linked or closed-pore surface or
• an adhesive.

8. Luminaire (1) according to one of the preceding claims, wherein the seal (10) further comprises a layer of an adhesion-enhancing liquid.

9. Luminaire (1) according to claim 8, wherein the liquid has a lower adhesive force than the remaining seal (10) with respect to the respectively adjacent housing section (20, 30), and/or
wherein the liquid is an adhesive.

10. Luminaire (1) according to one of the preceding claims, further comprising a pressure-regulating section to compensate for pressure between an interior space (5) surrounded by the seal (10) and the housing sections (20,30) and the immediate surroundings of the luminaire (1).

11. Luminaire (1) according to one of the preceding claims, wherein the seal (10) is designed as
• a molding,
• an injection molding,
• an extrusion part or
• a co-extrusion part.

12. Luminaire (1) according to one of the preceding claims, wherein the seal (10) is provided with luminous means (6),
wherein preferably
• the luminous means (6) is preferably mounted and connected to at least one printed circuit board (3), and
• at least one printed circuit board (3) is potted in the seal (10).

13. Luminaire according to claim 12, wherein at least one of the at least two housing sections (20, 30) and/or the seal (10) are/is formed from a translucent material.

## Revendications

1. Lampe (1),
• avec un premier tronçon de boîtier (20),
• un deuxième tronçon de boîtier (30) et
• un joint d'étanchéité (10) qui
- est formé d'un matériau flexible,
- est constitué et est disposé entre les deux tronçons de boîtier (20, 30) de telle sorte que, dans un état de compression, il est compressé de façon étanche entre les deux tronçons de boîtier (20, 30) de telle sorte qu'il existe une action d'adhérence entre le joint d'étanchéité (10) et le tronçon de boîtier (20, 30) adjacent, et
- dont la section transversale est en forme de X de sorte que, sur ses côtés tournés en direction des tronçons de boîtier (20, 30) respectifs, il présente des tronçons de pied (11, 12) élargis,
l'action d'adhérence étant obtenue au moins partiellement par le fait que le joint d'étanchéité (10) est formé et disposé de telle sorte que, dans l'état de compression, il se manifeste une action d'aspiration entre le joint d'étanchéité (10) et au moins un des deux tronçons de boîtier (20, 30).

2. Lampe (1) selon la revendication 1, présentant en outre un moyen de serrage (40) qui est disposé de telle sorte qu'il comprime les tronçons de boîtier (20, 30) respectivement dans la direction du joint d'étanchéité (10) de telle sorte que le joint d'étanchéité (10) est comprimé entre les deux tronçons de boîtier (20, 30) de façon étanche et se trouve ainsi dans l'état de compression,
le moyen de serrage (40) étant de préférence formé au moyen de crampons (40) constitués de façon élastique qui
• sont disposés côté périphérie extérieure sur les deux tronçons de boîtier (20, 30) en entourant ces derniers et
• sont écartés par les deux tronçons de boîtier (20, 30) et le joint d'étanchéité (10) et sont ainsi serrés.

3. Lampe (1) selon la revendication 1 ou 2, l'action d'aspiration étant obtenue par le fait que, dans un état de non-compression, le joint d'étanchéité (10) englobe complètement, avec le tronçon de boîtier (20, 30) au moins au nombre de un, une cavité qui est au moins réduite dans l'état de compression du joint d'étanchéité (10), la cavité résultant de préférence du fait que, sur un côté dirigé vers le tronçon de boîtier (20, 30) au moins au nombre de un, le joint d'étanchéité (10) présente une concavité (13) dirigée en direction du tronçon de boîtier (20, 30) au moins au nombre de un.

4. Lampe (1) selon l'une des revendications précédentes, le joint d'étanchéité (10) étant en engrènement par liaison de forme avec au moins un des deux tronçons de boîtier (20, 30), et/ou le joint d'étanchéité (10) étant mis en place par liaison de force et/ou de forme sur un des tronçons de boîtier (20, 30).

5. Lampe (1) selon l'une des revendications précédentes, le joint d'étanchéité (10) étant formé dans un matériau à deux composants.

6. Lampe (1) selon l'une des revendications précédentes,
le joint d'étanchéité (10) étant constitué de façon périphérique,
le joint d'étanchéité (10) étant de préférence
• découpé dans un matériau sans fin, et
• dont les extrémités qui en résultent sont jointes bout à bout.

7. Lampe (1) selon l'une des revendications précédentes, le joint d'étanchéité (10) étant constitué à partir
• d'un silicone,
• d'un composé de silicone,
• d'une colle thermofusible,
• d'un élastomère avec une surface réticulée ou respectivement à pores fermés ou
• d'une colle adhérente.

8. Lampe (1) selon l'une des revendications précédentes, le joint d'étanchéité (10) présentant en outre une couche d'un liquide renforçant l'adhérence.

9. Lampe (1) selon la revendication 8, le liquide présentant une force d'adhérence plus faible que le reste du joint d'étanchéité (10) par rapport au tronçon de boîtier (20, 30) respectivement adjacent, et/ou
le liquide étant une colle.

10. Lampe (1) selon l'une des revendications précédentes, présentant en outre un tronçon de régulation de pression, formé pour permettre un équilibrage de pression à partir d'un espace intérieur (5) entouré par le joint d'étanchéité (10) et les tronçons de boîtier (20, 30) vers un environnement immédiat de la lampe (1).

11. Lampe (1) selon l'une des revendications précédentes, le joint d'étanchéité (10) étant constitué en tant que
• pièce moulée
• pièce moulée par injection
• pièce extrudée ou
• pièce co-extrudée.

12. Lampe (1) selon l'une des revendications précédentes, le joint d'étanchéité (10) étant muni de moyens d'éclairage (6),
• les moyens d'éclairage (6) étant mis en place et branchés sur au moins un circuit imprimé (3) et
• le circuit imprimé (3) au moins au nombre de un étant coulé dans le joint d'étanchéité (10).

13. Lampe (1) selon la revendication 12, au moins un des au moins deux tronçons de boîtier (20, 30) et/ou le joint d'étanchéité (10) étant formé(s) d'un matériau translucide.
